# EUROPEAN PATENT SPECIFICATION

(11) **EP 1 752 954 B1**
(45) Date of publication and mention of the grant of the patent: **21.07.2010**
(21) Application number: 05017537.1
(22) Date of filing: 11.08.2005
(51) Int. Cl.: G09G 3/32, H01L 27/32, B60K 35/00

(54) **Display**
Anzeigegerät
Dispositif d'affichage

(43) Date of publication of application: 14.02.2007
(73) Proprietor: Johnson Controls Automotive Electronics GmbH, 75196 Remchingen (DE)
(72) Inventor: Kammerer, Gerhard, 75203 Königsbach (DE); Cheveau, Cedric, 75018 Paris (FR); Süss, Manfred, 75196 Remchingen (DE); Fournier, Joël, 95000 Cergy (FR)
(74) Representative: Wolff, Felix

(56) References cited:
- WO-A-03/094255
- US-A- 5 757 139
- US-A1- 2003 169 590
- US-A1- 2004 164 671
- US-A1- 2004 251 820
- US-B1- 6 274 980

## Description

The present invention relates to the display and/or lighting for the interior of a vehicle comprising at least two stacked layers each comprising at least one OLED.

In order to come up with new designs for instrument panels, new illumination systems are needed. US-6,291,788 B1, DE 100 52 580 A1, DE 197 08 610 A1, DE 199 03 201 A1, US-A-2004 251820 (including the features of the preamble of claim 1) and DE 101 39 001 A1 suggest indicating instruments which are illuminated by an organic light emitting diode (OLED). However, these illuminations have the disadvantage, that the illumination is in many cases not bright enough, not long lasting enough and/or that a multicolour-display can not be realized.

It was therefore the objective of the present invention to overcome the disadvantages of the displays and/or lighting systems according to the state of the art.

The problem is solved with a display and/or a lighting for the interior of a vehicle according to claim 1.

It was totally surprising and could not have been expected by a person skilled in the art that::
- the durability of the illumination of a display or the lighting is increased,
- the intensity of the illumination of a display or the lighting can be increased,
- several different colours can be realized with the inventive display,
- the colour of the display and/or the lighting can be changed,
- several colours can be realized side by side without mixing zones.

According to the present invention, the display and/or lighting comprises at least two stacked layers. These layers comprise at least two or more OLED which at least partially, preferably entirely, overlap, so that the OLEDs are at least partially stacked upon each other.

An organic light emitting diode (OLED) is a thin film light emitting diode, in which the emissive layer is an organic compound. This layer is placed between two conductors.

After an electrical current is applied, a bright light is emitted.. These systems are very thin, usually less than 500 nm. The films are flexible and can therefore be used for almost arbitrarily shaped displays or lightings. When used to produce displays, OLED technology produces self-luminous displays that do not require back lighting. These properties result in thin, very compact displays. These displays also have a wide viewing angle up to 160° and require very little power, only 2-10 volts.

According to the present invention, the display comprises two layers which are stacked upon each other, each layer comprising at least two OLED. The OLED in each layers are identical. This embodiment of the present invention has the advantage, that the brightness of the display and/or lighting can be increased if the OLEDs in all layers are activated. If the OLED is only activated in one layer, the durability of the display can be increased; i. e. after the OLED in one layer has failed, the OLED in the other layer will be activated. Both layers can be activated with half power which increases the lifetime.

According to the present invention, the layers comprise two OLEDs which are different from each other. This embodiment of the present invention allows to realize multicolour displays with very sharp boundaries between the different colours.

In a preferred embodiment of the present invention, the OLEDs of only one layer are activated.

In another preferred embodiment of the present invention all OLEDs in the different layers are activated.

Preferably, the display according to the present invention are combined with LED- or OLED-symbols. A symbol according to the present invention is any symbol used in the instrumentation panel of a car.

Preferably, if not activated, the two stacked layers appear as a black background. This is for example achieved by a circular polarizer. This preferred embodiment of the present invention has the advantage, that the OLEDs which are normally transparent in a non-activated condition appear as a black background.

Preferably, at least one of the OLED layers comprises a reflecting zone, so that all light emitted by the OLEDs is directed into one direction.

The invention is now explained with figures 1 - 8. These explanations do not limit the scope of protection of the present invention.

**Figure 1** shows one embodiment of the present invention with two identical OLEDs.

**Figure 2** shows an embodiment of the present invention whereas each layer comprises several OLEDs.

**Figure 3** shows an embodiment of the present invention with a circular polarizer and a mirror.

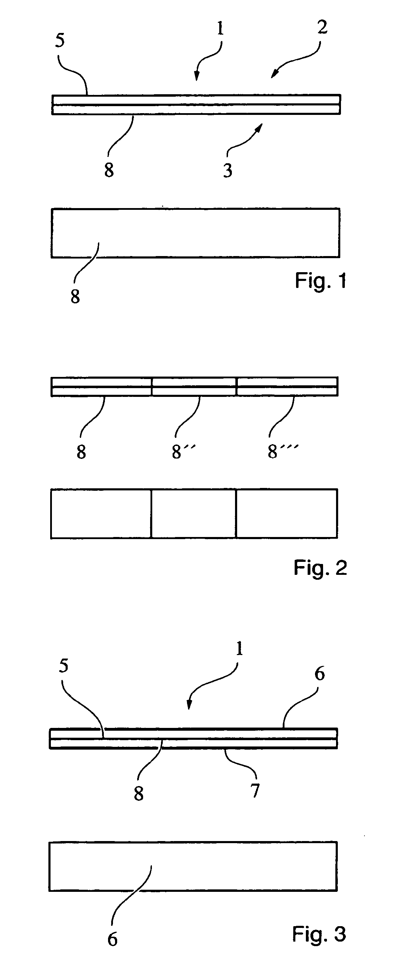

Figure 1 shows one embodiment of the inventive display 1 which comprises an upper layer 2 and a lower layer 3, whereas layer 2 comprises OLED 5 and layer 3 OLED 8. Both layers and thus the OLEDs are arranged on a support (not depicted). In the present example, the two OLEDs 5, 8 are identical in size and emit the same light frequencies; i. e. the same colours. The OLED 5 and the OLED 8 can be activated independently. This embodiment of the present invention has the advantage that the durability of the illumination can be prolonged if only one OLED is activated. As soon as this OLED fails, the other OLED will be automatically activated or both OLED's are activated with half power which increases the lifetime. On the other hand, both OLEDs 5,8 can be activated simultaneously with full power which increases the brightness of the illumination.

Figure 2 essentially shows an example of a present invention which is similar to an example according to figure 1 with the difference that three distingued colour zones can be seen on the display. The OLEDs in layer 2 and 3 can be activated separately or simultaneously as already explained in the example according to figure 1.

In figure 3 an other example of the embodiment of the present invention is shown. In this example, the two layers 2, 3 comprise at the bottom a mirror 7 which reflects all the emitted light into one direction. On top, the inventive display according to the present example has a circular polarizer 6 so that the displays if not activated appear as a black surface. The person skilled in the art understands that the mirror and the circular polarizer can also be combined with the embodiments of the present invention according to figure 1 - 2.

### Reference list

- 1: Display, lighting
- 2.3: layer
- 5: OLEDs
- 6: Circular polarizer
- 7: Mirror
- 8,8',8",8'": front-side of the display

## Claims

1. Display (1) and/or lighting for the interior of a vehicle, comprising at least two stacked layers (2, 3) each layer (2, 3) comprising at least two OLEDs (5), which are different **characterized in, that** the OLEDs (5 ) in each layer are identical.

2. Display according to one of the preceding claims, **characterized in, that** it comprises symbol shaped LEDs.

3. Display according to one of the preceding claims, **characterized in, that** it comprises symbol shaped OLEOs.

4. Display according to one of the preceding claims, **characterized in, that** it comprises a circular polarizer (6).

## Patentansprüche

1. Anzeigegerät (1) und/oder Beleuchtung für den Innenraum eines Fahrzeugs, umfassend mindestens zwei gestapelte Schichten (2, 3), wobei jede Schicht (2, 3) mindestens zwei OLEDs (5) umfasst, die verschieden sind, **dadurch gekennzeichnet, dass** die OLEDs (5) in jeder Schicht identisch sind.

2. Anzeigegerät nach einem der vorhergehenden Ansprüche, **dadurch gekennzeichnet, dass** es symbolförmige LEDs umfasst.

3. Anzeigegerät nach einem der vorhergehenden Ansprüche, **dadurch gekennzeichnet, dass** es symbolförmige OLEDs umfasst.

4. Anzeigegerät nach einem der vorhergehenden Ansprüche, **dadurch gekennzeichnet, dass** es einen Zirkularpolarisator (6) umfasst.

## Revendications

1. Dispositif d'affichage (1) et/ou éclairage pour l'intérieur d'un véhicule, comprenant au moins deux couches empilées (2, 3), chaque couche (2, 3) comprenant au moins deux DEL organiques (5), qui sont différentes, **caractérisé en ce que** les DEL organiques (5) dans chaque couche sont identiques.

2. Dispositif d'affichage selon l'une quelconque des revendications précédentes, **caractérisé en ce qu'**il comprend des DEL en forme de symbole.

3. Dispositif d'affichage selon l'une quelconque des revendications précédentes, **caractérisé en ce qu'**il comprend des DEL organiques en forme de symbole.

4. Dispositif d'affichage selon l'une quelconque des revendications précédentes, **caractérisé en ce qu'**il comprend un polariseur circulaire (6).
